# EUROPÄISCHE PATENTSCHRIFT

(11) **EP 2 700 082 B1**
(45) Veröffentlichungstag und Bekanntmachung des Hinweises auf die Patenterteilung: **15.08.2018**
(21) Anmeldenummer: 12714576.1
(22) Anmeldetag: 30.03.2012
(51) Int. Cl.: H01J 37/34, C23C 14/34

(54) **VERFAHREN ZUM BESCHICHTEN VON SUBSTRATEN UND HOCHLEISTUNGSZERSTÄUBUNGSQUELLE DAZU**
METHOD FOR COATING SUBSTRATES AND HIGH-POWER SPUTTERING SOURCE THEREFOR
PROCÉDÉ DE REVÊTEMENT DE SUBSTRATS ET SOURCE DE PULVÉRISATION HAUTE PUISSANCE ASSOCIÉE

(30) Priorität: 20.04.2011 DE 102011018363
(43) Veröffentlichungstag der Anmeldung: 26.02.2014
(73) Patentinhaber: Oerlikon Surface Solutions AG, Pfäffikon, 8808 Pfäffikon (CH)
(72) Erfinder: KRASSNITZER, Siegfried, A-6800 Feldkirch (AT); RUHM, Kurt, FL-9486 Schaanwald (LI)
(74) Vertreter: Kempkens, Anke
(86) Internationale Anmeldenummer: PCT/EP2012/001414
(87) Internationale Veröffentlichungsnummer: WO 2012/143087

(56) Entgegenhaltungen:
- DE-A1-102006 017 382
- DE-A1-102008 021 912
- DE-U1-202010 001 497
- US-B1- 6 183 614
- EHIASARIAN A P ET AL: "INFLUENCE OF HIGH POWER DENSITIES ON THE COMPOSITION OF PULSED MAGNETRON PLASMAS", VACUUM, PERGAMON PRESS, GB, Bd. 65, Nr. 2, 19. April 2002 (2002-04-19) , Seiten 147-154, XP001189721, ISSN: 0042-207X, DOI: 10.1016/S0042-207X(01)00475-4
- E. BROITMAN ET AL: "Industrial-scale deposition of highly adherent CNx films on steel substrates", SURFACE AND COATINGS TECHNOLOGY, Bd. 204, Nr. 21-22, 1. August 2010 (2010-08-01), Seiten 3349-3357, XP55038818, ISSN: 0257-8972, DOI: 10.1016/j.surfcoat.2010.03.038

## Beschreibung

Die vorliegende Erfindung bezieht sich auf ein Verfahren zum Beschichten von Substraten mittels Magnetron-Zerstäuben.

Im Rahmen dieser Beschreibung wird "Sputtern" gleichbedeutend mit "Zerstäuben" verwendet.

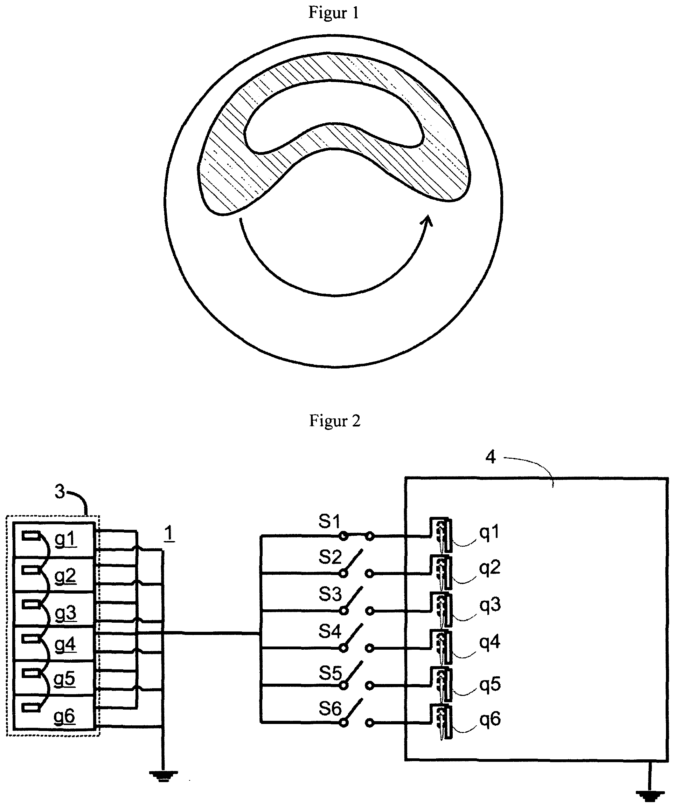

Beim Sputtern wird ein Target (Kathode) mit Ionen beschossen, was dazu führt, dass Material vom Target abgetragen wird. Die Beschleunigung der Ionen in Richtung Targetoberfläche aus einen Plasma heraus wird mittels eines elektrischen Feldes erreicht. Beim Magnetronsputtern wird über der Targetoberfläche ein Magnetfeld aufgebaut. Auf diese Weise werden Elektronen im Plasma auf eine Spiralbahn gezwungen und kreisen über der Targetoberfläche. Durch deren verlängerten Weg erhöht sich die Zahl der Zusammenstösse Elektronen mit Atomen bzw. Ionen erheblich, was zu einer höheren Ionisation in diesem Bereich über der Targetoberfläche führt. Dadurch kommt es zu einem erhöhtem Sputterabtrag auf dem Target unmittelbar unter dem Bereich. Diese führt zu den für das Magnetronsputtern typischen Erosionsgräben mit darüber liegendem Racetrack. Ein solcher Erosionsgraben hat den Nachteil, dass grosse Bereiche des Targets im Wesentlichen nicht abgetragen werden. Targetmaterial ist jedoch häufig ein teures Material. Mitunter wird daher das das Magnetfeld aufbauende Magnetsystem hinter dem Target so ausgelegt, dass dies zu einem nierenförmigen Racetrack, wie in Figur 1 dargestellt, führt. Im Falle einer Rundkathode wird das Magnetsystem um die zentrale Achse der Rundkathode rotiert, so dass es im Wesentlichen zu einer gleichförmigen Abtragung des Targetmaterials kommt. Es bleibt jedoch der Nachteil des konventionellen Sputterns dass das abgetragene Material nur zu einem sehr geringen Prozentsatz ionisiert wird.

Die vorliegende Erfindung bezieht sich im Speziellen auf ein HIPIMS-Verfahren (HIPIMS = High Power Impulse Magnetron Sputtering). HIPIMS ist ein aus dem konventionellen Sputtern weiterentwickeltes Verfahren, das die Wirkung von pulsartigen Entladungen mit einer Pulsdauer im Bereich von Mikrosekunden bis Millisekunden mit Leistungsdichten grösser 100W/cm² nutzt. Die aufkommende HIPIMS-Technologie eliminiert den grossen Nachteil des konventionellen Sputterns, nämlich die sehr geringe Ionisierung der gesputterten Atome. So wurde vom Stand der Technik gezeigt, dass mittels der HIPIMS Technik je nach Material eine bis zu 100%-ige Ionisierung der gesputterten Teilchen erzielt werden kann. Dabei führt die zumindest kurzzeitig grosse auf das Target einwirkende Entladestromdichte zu dem erhöhten Ionisierungsgrad. Der erhöhte Ionisierungsgrad kann den Wachstumsmechanismus der Schichten verändern und hat somit Einfluss auf die Schichteigenschaften. U.a. führt dies zu einer höheren Haftfestigkeit.

Typische verwendeten mittleren Leistungsdichten liegen sowohl beim konventionellen Sputtern als auch beim HIPIMS im Bereich von 20W/cm². Bei hohen Belastungen kommt es zu bis zu 50W/cm² unter Verwendung von besonderen Targetkühleinrichtungen. Die entsprechenden Entladestromdichten liegen dabei im Bereich von bis zu 0.2A/cm². Vom Standpunkt der Plasmaphysik und der Elektrotechnik wären jedoch weit höhere Leistungsdichten und damit Entladestromdichten kein Problem. Im Wesentlichen ist jedoch die auf ein Sputtertarget anwendbare mittlere Leistung dadurch limitiert, dass der Targetkühlung technische Grenzen gesetzt sind. Aus diesem Grund wird bei dem HIPIMS-Verfahren die Sputterleistung in gepulster Form angelegt, wobei die Pulsdauer so kurz gewählt wird, dass es aufgrund der mittleren auf das Target einwirkenden Leistung nicht zur Übertemperatur kommt. Dabei ist klar, dass die Targettemperatur und die zulässige maximale Targettemperatur sehr stark vom Targetmaterial und dessen Wärmeleitfähigkeit und dessen mechanischen Eigenschaften abhängen.

Nachteilig dabei ist, dass die Pulstechnologie zu einem erheblichen apparativen Aufwand führt, da Generatoren verwendet werden müssen, welche in der Lage sind die Leistung zeitlich und räumlich in Sputter-Leistungspulse aufzuteilen. Dies wird mit der konventionellen Generator-Technologie nicht erreicht.

Um diesen Nachteil zu umgehen wird im Stand der Technik vorgeschlagen, auf ein im Vergleich zur Gesamtgrösse des Targets deutlich verkleinertes Racetrack überzugehen und dieses Racetrack über die Targetoberfläche wandern zu lassen. Beispielsweise wird in der US 6'413'382 von Wang et al ein Magnetsystem vorgeschlagen, welches zu einem Magnetron führt, das weniger als 20% der Targetoberfläche abdeckt. Das Magnetsystem ist rotierbar hinter der Targetfläche montiert, so dass das Racetrack im Wesentlichen die gesamte Targetoberfläche überstreichen kann. Dieser Ansatz vereinfacht zwar die Generatoren, auf Pulstechnologie völlig verzichtet werden kann dennoch nicht. Dementsprechend wird ein Puls/Pause Verhältnis von weniger als 10% angegeben.

Nachteilig hierbei ist allerdings, dass eine dementsprechend ausgelegte Apparatur ausschliesslich für HIPIMS-Anwendungen geeignet ist. Durch die stark reduzierte Racetrackgrösse ist die Sputterrate entsprechend gering. Soll zwischen HIPIMS-Schichten und konventionellen Sputterschichten abgewechselt werden können, so ist auch die entsprechende konventionelle Sputterrate für diese Schichten reduziert.

Einen ähnlichen Ansatz verfolgen Nyberg et al in WO03006703A1. Sie beschreiben dass eine erhöhte Entladestromdichte durch einen verkleinerten Sputterbereich erreicht wird. Um die höhere lokale Erhitzung zu kompensieren wird der Sputterbereich bewegt. Nyberg et al beschreiben ausserdem, dass bei einer industriellen Anwendung der reduzierte Sputterbereich mit hoher Geschwindigkeit auf dem Target bewegt werden muss, um ein Schmelzen der Oberfläche zu verhindern. Diese Technik erlaubt es jeden konventionellen Generator einzusetzen. Eine Möglichkeit wird darin gesehen, ein Target in mehrere Teile aufzuteilen, welche elektrisch voneinander getrennt sind. Im Folgenden werden diese Teile Teiltargets genannt. Ein Teiltarget soll dabei ein vollständig eigenständiges Target sein welches insbesondere bezüglich Leistungsbeaufschlagung von den anderen Teiltargets isoliert ist, wobei sich die Oberflächen meherer identischer Teiltargets zu der Targetgesamtfläche addieren. Indem man zu einem Zeitpunkt die gesamte Leistung auf eines dieser Teiltargets konzentriert ist es demnach möglich, den Ort, von dem aktuell zerstäubt wird, zu steuern. Durch An- und Abschalten der Teile ist es möglich ohne bewegliche Komponenten auszukommen.

Ein Nachteil der Anordnung von Nyberg et al ist die Tatsache, dass ein solcher Aufbau nicht im konventionellen Magnetronsputtern-Modus betrieben werden kann, da es nicht möglich ist oder technisch sehr aufwändig ist, die Leistung des einen Generators gleichmässig auf die verschiedenen Teile zu verteilen. Nachteilig bei dem Ansatz von Nyberg et al ist insbesondere auch, dass es auf jedem der zu- oder abschaltbaren Teiltargets zu einem festen Erosionsgraben kommt. Dies bedeutet, dass die Targetausnutzung deutlich schlechter ist als im Vergleich zu den von Wang et al beschriebenen rotierenden Magnetrons.

Weiter ist aus DE 10 2006 017 382 A1 und DE 20 2010 001 497 U1 bekannt, die Leistung einer HIPIMS Leistungsvorrichtung auf mehrere Kathoden simultan oder sequentiell zu verteilen. Es wäre daher wünschenswert eine Apparatur zur Verfügung zu haben, welche es gestattet, ohne aufwändige Pulsgeneratortechnologie ein HIPIMS-Verfahren durchzuführen, und aber in einfacher Weise in einen konventionellen Sputter-Modus umgeschalten können werden soll.

Erfindungsgemäss wird diese Aufgabe dadurch gelöst, dass ein Target in mehrere elektrisch isolierte eigenständige Teiltargets aufgeteilt wird welche durch eine Leistungsversorgungseinheit gespeist werden die im HIPIMS-Modus als Master-Slave Einheit konfiguriert ist. Unter Master -Slave Konfiguration ist der parallele Zusammenschluss der Ausgänge zweier oder mehrerer Generatoren zu verstehen, wobei die einzustellende Leistung an einem der Generatoren (dem Master) gewählt wird und die anderen Generatoren elektronisch so verbunden sind, dass sie dem Master in ihren Einstellungen folgen. Vorzugsweise sind zumindest so viele Generatoren in Master-Slave Konfiguration zusammengeschaltet wie es einzelne elektrisch isolierte Teiltargets gibt. An die einzelnen Teiltargets wird im HIPIMS-Modus nur so lange Leistung übertragen, wie dies ihre Kühlung zulässt. Im HIPIMS-Modus werden die Teiltargets der Reihe nach zu und abgeschaltet. Die Leistungsversorgungseinheit in Master-Slave Konfiguration muss demnach nie gleichzeitig bei allen Teiltargets die volle Leistung erbringen. Auf diese Weise kann ein kostengünstiger Generator zum Einsatz kommen. Soll konventionell gesputtert werden, so wir die Master-Slave Konfiguration aufgelöst und für jedes Teiltarget steht ein eigener Generator zu Verfügung. Ein Teiltarget kann dann mir einem Generator als eine eigenständige Sputterquelle betrieben werden. Stehen nach Auflösung der Master-Slave Konfiguration nicht so viele Generatoren wie Teiltargets zur Verfügung, so können einige Teiltargets dauerhaft abgeschaltet bleiben oder es wird mit der Abschaltung abgewechselt. Auf diese Weise wird erreicht, dass einfach vom HIPIMS-Modus auf den konventionellen Sputtermodus umgeschalten werden kann.

Vorzugsweise befinden sich hinter den Teiltargets jeweils bewegliche Magnetsysteme, welche dafür sorgen, dass der jeweilige Racetrack über das jeweilige Teiltarget wandert. Falls die Anlage im HIPIMS-Modus betrieben wird bewegen sich erfindungsgemäss die hinter den Teiltargets vorzugsweise rotierenden Magnetsysteme mit einer Frequenz, welche vorzugsweise mit der Frequenz des wiederkehrenden Leistungspulses der Sputterquelle kein rationnales Verhältnis bildet. Hierdurch ist sichergestellt ist, dass gleichmässig Material von der Targetoberfläche abgetragen wird.

Die Erfindung wird nun im Detail und anhand der Figuren beispielhaft genauer erläutert.
Figur 1 zeigt die Oberfläche eines Targets zusammen mit dem sich bewegenden Racetrack wie es gemäss Stand der Technik im konventionellen Sputtern eingesetzt wird.
Figur 2 zeigt eine erste Ausführungsform der vorliegenden Erfindung mit elektrisch isolierten Teiltargets, welche jeweils ein bewegtes Magnetsystem aufweisen, wobei die Leistungsversorgungseinheit aus mehreren Generatoren besteht, die in Master-Slave Konfiguration verbunden sind .
Figur 3 zeigt eine erste Ausführungsform der vorliegenden Erfindung mit elektrisch isolierten Teiltargets, welche jeweils ein bewegtes Magnetsystem aufweisen, wobei die Leistungsversorgungseinheit aus mehreren Generatoren besteht, die nicht in Master-Slave Konfiguration verbunden sind so dass jedem Teiltarget ein Generator zugeordnet ist und mit diesem als eine eigenständige Sputterquelle betrieben werden kann.
Figur 4 zeigt das simulierte Abkühlverhalten verschiedener Targetmaterialien nach einer 50 ms langen Einwirkung eines Leistungspulses.
Figur 5 zeigt spektroskopische Messungen an einer Lichtbogenentladung im Vergleich zu solchen Messungen an der erfindungsgemässen Plasmaentladung
Figur 6 zeigt spektroskopische Messungen an der Entladung eines konventionellen DC Sputter-Plasmas im Vergleich zu solchen Messungen an der erfindungsgemässen Plasmaentladung

Gemäss einer ersten Ausführungsform der vorliegenden Erfindung, wie in Figur 2 schematisch gezeigt, liefert eine Leistungsversorgungseinheit 3, über den Schalter S1 Spannung und Strom an die in einer Vakuumkammer 4 angeordnete Sputterquelle q1 zum Betreiben der Sputtervorrichtung in HIPIMS-Modus. Die Leistungsversorgungseinheit 3 ist aus mehreren Generatoren gl bis g6 aufgebaut die in Master-Slave Konfiguration verbunden sind. Sie kann als DC Generator der als gepulster DC Generator ausgelegt sein. Die Sputterquelle q1 ist als Magnetron-Sputterquelle mit Teiltarget ausgebildet, wobei gemäss einer bevorzugten Variante dieser Ausführungsform hinter dem Teiltarget der Sputterquelle q1 ein bewegliches, vorzugsweise rotierend gelagertes Magnetsystem ms1 vorgesehen ist. In der Anwendung wird durch bewegen, vorzugsweise rotieren des Magnetsystems ms1 der Racetrack über nahezu die gesamte Fläche des Targets der Sputterquelle q1 bewegt.

In die Vakuumkammer 4 wird Edelgas und/oder Reaktivgas wie z.B. N₂, O₂, C₂H₄, C₂H₂ zugeleitet, unter anderem um das Plasma für die Sputterentladung aufrecht erhalten zu können. Die Leistungsversorgungseinheit 3 liefert eine Sputterleistung welche, falls ununterbrochen an q1 anliegend über dem thermischen Limit der Sputterquelle q1 liegt. Die Sputterleistung ist jedoch geeignet eine Magnetron Entladung zu erzeugen, bei welcher die Stromdichte bezogen auf die Racetrackfläche des Magnetrons grösser als 0.2A/cm² ist.

Über die Schalter S2 bis S6 kann Spannung und Strom an die auch in der Vakuumkammer 4 angeordneten Sputterquellen q2 bis q6 angelegt werden. Diese Sputterquellen sind im Wesentlichen baugleich wie die Sputterquelle q1.

Insgesamt darf die mittlere Leistung auf eine einzelne Sputterquelle den durch das thermische Limit gegebenen Wert nicht übersteigen. Um dies zu erreichen wird der Reihe nach, nach eine gewissen Zeit, eine Sputterquelle abgeschaltet und die nächste angeschaltet, was zu Pulsfolgen führt. Waren alle Sputterquellen in Betrieb so kann wieder die erste Sputterquelle angeschaltet werden und der Zyklus von neuem beginnen, was zu einem periodischen Betrieb führt. Es sind beliebige Pulsfolgen möglich, welche die Einhaltung der maximalen mittleren Leistung am Target erlauben.

Die hinter den Sputterquellen sich bewegenden, vorzugsweise rotierenden Magnetsysteme bewegen sich mit einer Frequenz welche vorzugsweise mit der Frequenz des wiederkehrenden Leistungspulses angelegt an eine Sputterquelle kein rationnales Verhältnis bildet, wodurch sichergestellt ist, dass gleichmässig Material von der Targetoberfläche abgetragen wird.

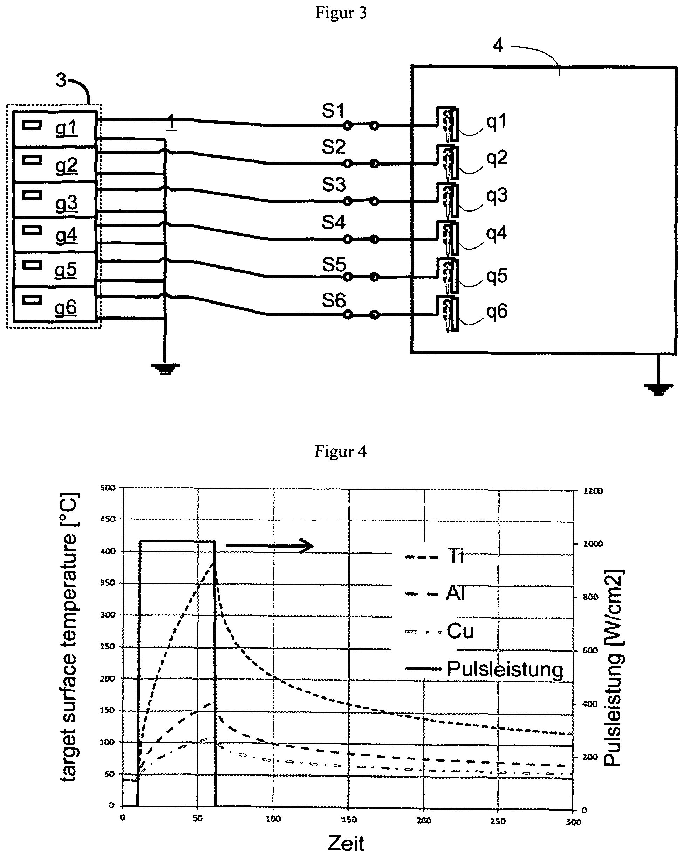

Soll auf konventionelles Sputtern umgestiegen werden, so wird die Master-Slave Konfiguration aufgegeben. Jeder Sputterquelle wird dann zumindest ein Generator zugeordnet. Die entsprechende Konfiguration ist in Figur 3 dargestellt. Liegen mehr Generatoren als Sputterquellen vor, so können die überzähligen Generatoren als Slave an bereits den Sputterquellen zugeordneten Generatoren angehängt werden.

Liegen weniger Generatoren als Sputterquellen vor, so können die überzähligen Sputterquellen entweder brach gelegt werden oder den verschiedenen Sputterquellen wird der Reihe nach und periodisch eine Leistungspause auferlegt, so dass sie für die Zeit der Leistungspause einen Generator freigeben.

Im konkreten Beispiel wurden beispielsweise 2DC Generatoren AE Pinacle mit je 20KW in Master/Slave Konfiguration verschaltet. Als maximale Sputterleistung standen somit 40kW zu Verfügung. Ein Rundmagnetron vom Typ wie in Figur 1 dargestellt mit einem Targetdurchmesser von 150mm wurde verwendet. Es wurde ein zeitlich einstellbarer Puls von 40kW Sputterleistung auf das Target geschaltet. Für ein Target dieser Grösse ist das thermische Limit erreicht wenn es im Mittel mit ca. 5kW beaufschlagt wird. Eine Berechnung der zeitlichen Entwicklung der Oberflächentemperatur in Abhängigkeit vom Targetmaterial ist in der Figur 4 dargestellt. Für eine Pulsleistung von 40kW bei Verwendung des oben geschilderten Magnetrons ist eine Leistungsdichte von 600 W/cm² bezogen auf die Racetrackfläche zu erwarten. Bei einer Entladespannung von 600V erreicht man damit eine Stromdichte von 1.67A/cm². Wie die Finite Elemente Simulation von Figur 4 zeigt, ist bei einer Sputter Leistungsdichte von 1000W/cm² und einer Pulsdauer von 50ms ein Temperaturanstieg von um nur etwa 50°C bis 100°C für Kupfer oder Aluminium sowie von um ca. 350°C für Titan zu erwarten. Eine Aufschmelzung der Oberfläche und Verdampfen derselben, wie sie oft erwähnt wird, kann, so lässt die Simulation schliessen, ausgeschlossen werden.

Nach der Pulsdauer von 50ms wird die gesamte Leistung auf in ein baugleiches weiteres Rundmagnetron eingespeist. Im Aufbau gemäss vorliegendem Beispiel umfass die Vakuumkammer 6 baugleiche Rundmagnetrons, die jeweils der Reihe nach aufgeschaltet werden. Nach einem Zeitintervall von 300ms wird das erste Rundmagnetron wieder aufgeschaltet. Die Rundmagnetrons können in der Vakuumkammer kreisförmig um einen Drehtisch, an dem die zu beschichtenden Substrate angebracht sind, angeordnet sein. Die Zuschaltung der einzelnen Rundmagnetrons kann in einer Reihenfolge gegen den Drehsinn des Drehtisches erfolgen, wodurch eine schnellere Rotation des Drehtisches simuliert wird.

Das Magnetsystem hinter der Targetoberfläche rotiert mit einer Frequenz von 180U/min. Dies bedeutet dass bei einer Pulswiederholung die alle 300ms stattfindet die beiden Frequenzen kein rationales Verhältnis bilden.

Mit der erfindungsgemässen Konfiguration wird ein starker Anstieg des Entladestroms innerhalb kurzer Zeit, beispielsweise 500µs erreicht, der sich auf stabilem Niveau während der gesamten Pulsdauer hält. Nachteilige transiente Vorgänge, wie sie typischerweise bei den HIPIMS-Verfahren aufgrund des Pulsens mit hoher Frequenz auftreten, werden mit dem erfindungsgemässen Verfahren vermieden. Dies kommt daher weil im erfindungsgemässen Verfahren die Pulsdauer mehrere Millisekunden beträgt und die transienten Vorgänge vernachlässigbar werden.

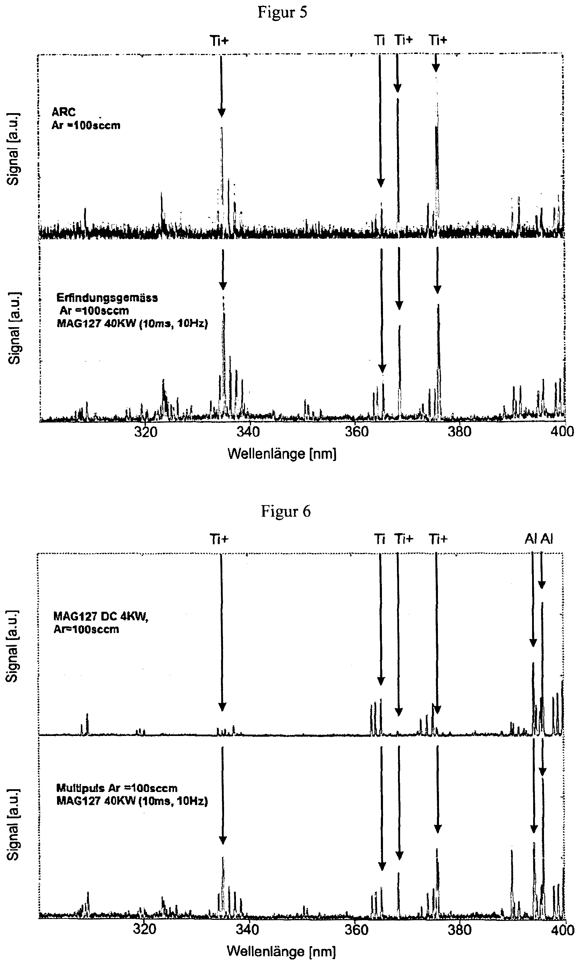

Gemäss einem zweiten Beispiel des erfindungsgemässen Verfahrens wurde an das oben beschriebene System Pulsleistung von 40kW und eine Pulsdauer von 10ms bei einer Wiederholfrequenz von 10Hz angelegt. Daraus ergab sich eine mittlere Leistung von 4kW pro Rundmagnetron. Hier lassen sich bis zu 10 Rundmagnetrons in die Vakuumkammer einbauen, welche alle mit der oben genannten Master/Slave Konfiguration gespeist werden können. Das Plasma der Entladung wurde spektroskopisch ausgewertet und mit dem Plasma einer Lichtbogenverdampfung verglichen. Im Beispiel war das Target ein Titantarget. Figur 5 zeigt die beiden Spektren im Vergleich, wobei diese jeweils auf ihre Intensität der Ti(0)-Linie bei 365.35nm normiert sind. Beide Entladungen zeigen starke optische Emissionen für Ti+ bei 336.12nm, 368.52nm und der in der Figur nicht aufgelösten Doppellinie mit 375.93nm und 376.132nm. Dies lässt die Schlussfolgerung zu, dass das erfindungsgemässe Sputterverfahren zu einer mit der Lichtbogenverdampfung vergleichbaren hohen Ionisation des vom Target abgetragenen Materials führt.

Gemäss einem dritten Beispiel wurde als Targetmaterial ein Titan-Aluminium verwendet mit einem Verhältnis von 50at% Ti und 50at% Al. Um das erfindungsgemässe Verfahren mit der konventionellen Sputtertechnik zu vergleichen wurde das Plasma der konventionellen Sputterbeschichtung und das Plasma des erfindungsgemässen Verfahrens spektroskopisch aufgezeichnet und miteinander verglichen. Für die konventionelle Sputterbeschichtung wurde die Konfiguration wie in Figur 3 gezeigt verwendet. Da für das Experiment allerdings lediglich 2 DC Generatoren zur Verfügung standen wurde jeweils eine Sputterquelle mit einem Generator gespeist, d.h. gleichzeitig zwei Sputterquellen gespeist und nach vorgegebenem Zeitintervall der Reihe nach die Leistungen auf zwei andere Sputterquellen gelenkt. Den entsprechenden Vergleich zeigt Figur 6. In beiden Fällen betrug die mittlere Sputterleisung 4kW. Die Spektren wurden auf die Al(0) Linien 394.4nm und 396.15nm normiert. Es fällt auf, dass im Falle der konventionellen DC-Entladung die Linien für Ionen wie Al+ bei 390.07nm, Ti+ bei der Doppellinie 375.93nm und 376.132, sowie bei 368.52nm und 336.12nm weitgehend fehlen. Die lässt ebenfalls den Schluss zu, dass beim erfindungsgemässen Verfahren ein hoher Ionisierungsgrad der vom Target abgetragenen Materie vorliegt.

Gemäss einer weiteren Ausführungsform der vorliegenden Erfindung wird das Verfahren als Dual-Magnetron Verfahren ausgelegt. Dabei wechselt die Sputterleistung während eines Pulses der mehrere Mikrosekunden anhält zwischen zumindest zwei Sputtermagnetrons mit einer Wechselfrequenz von typischerweise zwischen 20-60kHz, wobei jeweils abwechselnd die Targetoberfläche zur Kathode oder Anode wird. Um die thermische Belastung der Tragets nicht zu überschreiten wird die angelegte Leistung auf die Magnetronpaare jeweils zeitlich limitiert indem nach dem Puls auf ein weiteres Magnetronpaar umgeschaltet wird.

Sämtliche Beispiele wurden anhand von Rundkathoden diskutiert. Es ist dem Fachmann aber unmittelbar klar, dass dasselbe erfinderische Konzept in einfacher Weise auf Rechteckkathoden übertragbar ist. Ein besonderer Vorteil der vorliegenden Erfindung liegt darin, dass ein einfacher DC Generator verwendet werden kann dessen Gesamtleistung von beispielsweise 40kW in die Beschichtungskammer eingebracht werden kann aufgrund der erfindungsgemässen Verschaltung des Generators mit den einzelnen Sputterquellen gleichzeitig ein Ionisierungsgrad erzielt werden kann, welcher im Rahmen eines Sputterverfahrens typischerweise lediglich mit hochkomplexen Pulsgeneratoren erzielbar ist. In bevorzugten Ausführungsformen der vorliegenden Erfindung ist jeweils hinter den Sputtertargets ein bewegtes Magnetfeldsystem vorgesehen, welches für eine Bewegung des Racetracks über das Target sorgt.

Das erfindungsgemässe Verfahren und die erfindungsgemässe Apparatur erlaubt in einfacher Weise die Umstellung vom erfindungsgemässen Sputtern welches auf eine hohe Ionenkonzentration führt zu konventionellem Sputtern mit niedriger Ionenkonzentration.

Im Rahmen der vorliegenden Beschreibung wurde ein Verfahren offenbart zur Erzeugung einer Plasmaentladung mit einer Entladungsstromdichte die zumindest in manchen Bereichen lokal grösser 0.2A/cm² ist, mit den Schritten:
- Bereitstellen einer Leistungsversorgungseinheit mit einer vorgegebenen maximalen Leistung
- Bereitstellen von mindestens zwei Magnetron Sputterquellen mit jeweils vorgegebenem Racetrack und vorgegebenem thermischen Limit, wobei das Racetrack so klein ausgelegt wird, dass bei einwirken der maximalen Leistung der Leistungsversorgungseinheit auf jeweils eine der Magnetron Sputterquellen die Entladungsstromdichte grösser als 0.2A/cm² ist;
- Mittels der Leistungsversorgungseinheit Einspeisung einer ersten Leistung in eine erste der mindestens zwei Magnetron Sputterquellen für eine erstes Zeitintervall, wobei die erste Leistung gross genug gewählt ist so dass an der Magnetron Sputterquelle zumindest in einem Bereich lokal eine Entladungsstromdichte grösser als 0.2A/cm² entsteht und wobei das erste Zeitintervall genügend klein gewählt ist, so dass das vorgegebene thermische Limit der ersten Magnetron Sputterquelle nicht überschritten wird;
- Mittels der Leistungsversorgungseinheit Einspeisung einer zweiten Leistung in eine zweite der Magnetron Sputterquellen für eine zweites Zeitintervall, wobei die zweite Leistung gross genug gewählt ist so dass an der zweiten Magnetron Sputterquelle zumindest in einem Bereich lokal eine Entladungsstromdichte grösser als 0.2A/cm² entsteht und wobei das zweite Zeitintervall genügend klein gewählt ist, so dass das vorgegebene thermische Limit der zweiten Magnetron Sputterquelle nicht überschritten wird;
dadurch gekennzeichnet, dass die Leistungsversorgungseinheit zumindest zwei Generatoren umfasst die in Master-Slave Konfiguration miteinander verbunden sind und dass die beiden Zeitintervalle nicht vollständig überlappen.

Es kann eine dritte und vorzugsweise weitere Magnetron Sputterquellen bereitgestellt werden mit jeweils vorgegebenem Racetrack und jeweils vorgegebenem thermischen Limit, wobei die Racetracks so ausgelegt sind, dass bei einwirken der maximalen Leistung der Leistungsversorgungseinheit auf jeweils eine der Magnetron Sputterquellen die Entladungsstromdichte grösser als 0.2A/cm² ist und die Leistungsversorgungseinheit zumindest so viele Slave Generatoren dass die Anzahl der Slave Generatoren und der Mastergenerator auf eine Generatorenzahl führen, die gleich oder grösser als die Anzahl der Magnetron Sputterquellen ist.

Die Zeitintervalle können durch periodisch wiederkehrende Intervalle zusammengesetzt werden und daher periodische Pulse bilden.

Hinter zumindest einem der Targets der Magnetron-Sputterquellen kann ein bewegliches, vorzugsweise rotierendes Magnetsystem vorgesehen sein, welches zu einem bewegten Racetrack führt, dessen Ausbreitung deutlich kleiner als die Targetoberfläche, jedoch grösser als 20% der Targetoberfläche ist.

Es wurde eine Magnetron Sputteranlage mit zwei oder mehr Magnetron Sputterquellen und einer Leistungsversorgungseinheit offenbart, wobei die Leistungsversorgungseinheit eine Anzahl Generatoren umfasst, welche mindestens der Anzahl der Magnetron Sputterquellen entspricht und Mittel vorgesehen sind welche einerseits konfiguriert sind die in der Leistungsversorgungseinheit vorhandenen Generatoren zu mit einem Master und zumindest einem Slave zu konfigurieren und eine Schaltung vorgesehen ist mit der die Leistung der so konfigurierten Leistungsversorgungseinheit der Reihe nach auf die Magnetron Sputterquellen aufgebracht werden kann und die Mittel andererseits konfiguriert sind die Leistungsversorgungseinheit als Anzahl isolierter Generatoren zu konfigurieren und mit der Schaltung die Leistung jeweils zumindest eines Generators auf jeweils eine Magnetron Sputterquelle gebracht werden kann.

## Patentansprüche

1. Verfahren zur Erzeugung einer Plasmaentladung mit einer Entladungsstromdichte die zumindest in manchen Bereichen lokal grösser 0.2A/cm² ist, mit den Schritten:
- Bereitstellen einer Leistungsversorgungseinheit (3) mit einer vorgegebenen maximalen Leistung
- Bereitstellen von mindestens zwei Magnetron Sputterquellen (q1-q6) mit jeweils vorgegebenem Racetrack und vorgegebenem thermischen Limit, wobei das Racetrack so klein ausgelegt wird, dass bei einwirken der maximalen Leistung der Leistungsversorgungseinheit (3) auf jeweils eine der Magnetron Sputterquellen (q1-q6) die Entladungsstromdichte grösser als 0.2A/cm² ist;
- Mittels der Leistungsversorgungseinheit (3) Einspeisung einer ersten Leistung in eine erste der mindestens zwei Magnetron Sputterquellen für eine erstes Zeitintervall, wobei die erste Leistung gross genug gewählt ist so dass an der Magnetron Sputterquelle zumindest in einem Bereich lokal eine Entladungsstromdichte grösser als 0.2A/cm² entsteht und wobei das erste Zeitintervall genügend klein gewählt ist, so dass das vorgegebene thermische Limit der ersten Magnetron Sputterquelle nicht überschritten wird;
- Mittels der Leistungsversorgungseinheit (3) Einspeisung einer zweiten Leistung in eine zweite der Magnetron Sputterquellen für eine zweites Zeitintervall, wobei die zweite Leistung gross genug gewählt ist so dass an der zweiten Magnetron Sputterquelle zumindest in einem Bereich lokal eine Entladungsstromdichte grösser als 0.2A/cm² entsteht und wobei das zweite Zeitintervall genügend klein gewählt ist, so dass das vorgegebene thermische Limit der zweiten Magnetron Sputterquelle nicht überschritten wird;
wobei die beiden Zeitintervalle nicht vollständig überlappen; **dadurch gekennzeichnet, dass** die Leistungsversorgungseinheit (3) zumindest zwei Generatoren (g1-g6) umfasst die in Master-Slave Konfiguration miteinander verbunden sind.

2. Verfahren nach Anspruch 1, **dadurch gekennzeichnet, dass** eine dritte und vorzugsweise weitere Magnetron Sputterquellen bereitgestellt werden mit jeweils vorgegebenem Racetrack und jeweils vorgegebenem thermischen Limit, wobei die Racetracks so ausgelegt sind, dass bei einwirken der maximalen Leistung der Leistungsversorgungseinheit auf jeweils eine der Magnetron Sputterquellen die Entladungsstromdichte grösser als 0.2A/cm² ist und die Leistungsversorgungseinheit zumindest so viele Slave Generatoren dass die Anzahl der Slave Generatoren und der Mastergenerator auf eine Generatorenzahl führen, die gleich oder grösser als die Anzahl der Magnetron Sputterquellen ist..

3. Verfahren nach einem der Ansprüche 1 und 2, **dadurch gekennzeichnet, dass** die Zeitintervalle durch periodisch wiederkehrende Intervalle zusammengesetzt werden und daher periodische Pulse bilden.

4. Verfahren nach einem der vorhergehenden Ansprüche, **dadurch gekennzeichnet, dass** hinter zumindest einem der Targets der Magnetron-Sputterquellen ein bewegliches, vorzugsweise rotierendes Magnetsystem vorgesehen wird, welches zu einem bewegten Racetrack führt, dessen Ausbreitung deutlich kleiner als die Targetoberfläche, jedoch grösser als 20% der Targetoberfläche ist.

5. Magnetron Sputteranlage mit zwei oder mehr Magnetron Sputterquellen (q1-q6) und einer Leistungsversorgungseinheit (3), wobei die Leistungsversorgungseinheit (3) eine Anzahl Generatoren (g1-g6) umfasst, welche mindestens der Anzahl der Magnetron Sputterquellen (q1-q6) entspricht, und Mittel vorgesehen sind, welche einerseits konfiguriert sind, die in der Leistungsversorgungseinheit (3) vorhandenen Generatoren (g1-g6) zu mit einem Master und zumindest einem Slave zu konfigurieren, und eine Schaltung (S1-S6) vorgesehen ist, mit der die Leistung der so konfigurierten Leistungsversorgungseinheit (3) der Reihe nach auf die Magnetron Sputterquellen (q1-q6) aufgebracht werden kann, und die Mittel andererseits konfiguriert sind, die Leistungsversorgungseinheit (3) als Anzahl isolierter Generatoren zu konfigurieren, und mit der Schaltung die Leistung jeweils zumindest eines Generators auf jeweils eine Magnetron Sputterquelle gebracht werden kann.

## Claims

1. Method for generating a plasma discharge with a discharge current density that is at least in some areas locally greater than 0,2A/cm², with the steps of:
- providing a power supply unit (3) with a predefined maximum output
- providing at least two magnetron sputtering sources (q1-q6) with a predefined racetrack each and predefined thermal limit, wherein the racetrack is designed so small that when the maximum output of the power supply unit (3) is applied on one each of the magnetron sputtering sources (q1-q6), the discharge current density is greater than 0,2A/cm²;
- by means of the power supply unit (3), feeding a first output in a first of the at least two magnetron sputtering sources for a first time interval, wherein the first output is chosen sufficiently high so that at the magnetron sputtering source a discharge current density greater than 0.2A/cm2 is generated at least in one area locally and wherein the first time interval is chosen sufficiently small so that the predefined thermal limit of the first magnetron sputtering source is not exceeded;
- by means of the power supply unit (3), feeding a second output in a second of the magnetron sputtering sources for a second time interval, wherein the second output is chosen high enough so that at the second magnetron sputtering source a discharge current density greater than 0.2A/cm² is generated at least in one area locally and wherein the second time interval is chosen sufficiently small so that the predefined thermal limit of the second magnetron sputtering source is not exceeded;
wherein the two time intervals do not completely overlap;
**characterized in that** the power supply unit (3) comprises at least two generators (g1-g6) that are connected to one another in a master-slave configuration.

2. Method according to claim 1, **characterized in that** a third and preferably further magnetron sputtering sources can be provided with a predefined racetrack each and predefined thermal limit each, wherein the racetracks are designed in such a way that, when the maximum output of the power supply unit is applied on one each of the magnetron sputtering sources, the discharge current density is greater than 0,2A/cm² and the power supply unit at least so many slave generators that the number of slave generators and the master generator result in a number of generators that is equal to or greater than the number of the magnetron sputtering sources.

3. Method according to one of the claims 1 and 2, **characterized in that** the time intervals are composed of periodically recurring intervals and thus form periodic impulses.

4. Method according to one of the preceding claims, **characterized in that** behind at least one of the targets of the magnetron sputtering sources, a movable, preferably rotating magnet system can be provided that results in a moving racetrack whose propagation is considerably smaller than the target surface, yet greater than 20% of the target surface.

5. Magnetron sputtering facility with two or more magnetron sputtering sources (q1-q6) and one power supply unit (3), wherein the power supply unit (3) comprises a number of generators (g1 - g6) that corresponds at least to the number of the magnetron sputtering sources (q1-q6) and means are provided that, on the one hand, are configured, to configure the generators (g1-g6) available in the power supply unit (3) with one master and at least one slave and a switch (S1-S6) is provided with which the output of the power supply unit (3) thus configured can be applied in succession to the magnetron sputtering sources (q1-q6) and the means, on the other hand, are configured, to configure the power supply unit (3) as a number of isolated generators and by means of the switch the power of at least one generator respectively can be brought onto one magnetron sputtering source respectively.

## Revendications

1. Procédure pour produire une décharge de plasma ayant une densité du courant de décharge qui du moins dans quelques domaines est localement supérieure à 0,2 A/cm² avec les étapes:
- founir une unité d'alimentation de puissance (3) ayant une puissance maximale prédéfinie
- fournir au moins deux sources de pulvérisation cathodique à magnétron (q1-q6) ayant chacune une piste de course (racetrack) prédéfinie et une limite thermique prédéfinie, la piste de course (racetrack) étant désignée tellement petite que, si la puissance maximale de l'unité d'alimentation de puissance (3) est appliquée sur une des sources de pulvérisation cathodique à magnétron (q1-q6), la densité du courant de décharge est supérieure à 0,2A/cm².
- au moyen de l'unité d'alimentation de puissance (3) fournir une première puissance dans une première des au moins deux sources de pulvérisation cathodique à magnétron pour un premier intervalle de temps, la première puissance étant choisie suffisamment grande de sorte qu'une densité du courant de décharge supérieure à 0,2A/cm² est localement générée à la source de pulvérisation cathodique à magnétron du moins dans un domaine et le premier intervalle de temps étant choisi suffisamment petit de sorte que la limite thermique prédéfinie de la première source de pulvérisation cathodique à magnétron n'est pas dépassée;
- au moyen de l'unité d'alimentation de puissance (3) fournir une deuxième puissance dans une deuxième des sources de pulvérisation cathodique á magnétron pour un deuxième intervalle de temps, la deuxième puissance étant choisie suffisamment grande de sorte qu'une densité du courant de décharge supérieure à 0.2A/cm² est localement générée à la deuxième source de pulvérisation cathodique à magnétron du moins dans un domaine et le deuxième intervalle de temps étant choisi suffisamment petit de sorte que la limite thermique prédéfinie de la deuxième source de pulvérisation cathodique à magnétron n'est pas dépassée;
les deux intervalles de temps ne se chevauchant pas complétement; **caractérisé par le fait que** l'unité d'almentation de puissance (3) comprend du moins deux générateurs (g1-g6) qui sont connectés l'un à l'autre dans une configuration master-slave (maître - esclave).

2. Procédure selon la revendication 1 **caractérisée par le fait qu'**une troisième et de préférence d'autres sources de pulvérisation cathodique à magnétron sont fournies ayant chacune une piste de course (racetrack) prédéfinie et une limite thermique prédéfinie, les pistes de course (racetrack) étant désignées de manière que, si la puissance maximale de l'unité d'alimentation de puissance est appliquée sur une des sources de pulvérisation cathodique à magnétron, la densité du courant de décharge est supérieure à 0,2A/cm² et l'unité d'alimentation de puissance du moins tant de générateurs esclave (slave generators) que le nombre des générateurs esclaves et le générateur maître conduisent à un nombre de générateurs qui est égal ou supérieur au nombre des sources de pulvérisation cathodiques à magnétron.

3. Procédure selon l'une des revendications 1 et 2 **caractérisée par le fait que** les intervalles de temps sont composés par des intervalles récurrant périodiquement et forment ainsi des impulsions périodiques.

4. Procédure selon l'une des revendications précédentes **caractérisée par le fait que** derrière du moins une des cibles des sources de pulvérisation cathodique à magnétron un système magnétique mobile, de préférence tournant est prévu qui conduit à une piste de course (racetrack) en mouvement dont la propagation est considérablement inférieure à la surface de la cible, mais supérieure à 20% de la surface de la cible.

5. Dispositif de pulvérisation cathodique à magnétron avec deux ou plusieurs sources de pulvérisation cathodique à magnétron (q1-q6) et une unité d'alimentation de puissance (3), l'unité d'alimentation de puissance (3) comprenant un nombre de générateurs (g1-g6) qui correspond au moins au nombre des sources de pulvérisation cathodique à magnétron (q1 - q6) et des moyens étant prévus qui, d'une part, sont configurés de configurer les générateurs (g1-g6) disponibles dans l'unité d'alimentation de puissance (3) avec un maître (master) et du moins un esclave (slave) et un circuit (S1-S6) étant prévu qui permet d'appliquer la puissance de l'unité d'alimentation de puissance (3) ainsi configurée l'une après l'autre aux sources de pulvérisation cathodique à magnétron (q1-q6) et les moyens, d'autre part, sont configurés de configurer l'unité d'alimentation de puissance (3) comme nombre de générateurs isolés et au moyen du circuit la puissance de du moins un générateur respectivement peut être appliquée sur une source de pulvérisation cathodique à magnetron respectivement.
